# EUROPÄISCHE PATENTSCHRIFT

(11) **EP 1 691 486 B1**
(45) Veröffentlichungstag und Bekanntmachung des Hinweises auf die Patenterteilung: **27.10.2010**
(21) Anmeldenummer: 06000968.5
(22) Anmeldetag: 18.01.2006
(51) Int. Cl.: H03K 17/96

(54) **Bedienverfahren und Bedieneinrichtung für ein Elektrogerät**
Operating method and apparatus for an electrical appliance
Méthode er dispositif de commande pour un dispositif électrique

(30) Priorität: 20.01.2005 DE 102005004066
(43) Veröffentlichungstag der Anmeldung: 16.08.2006
(73) Patentinhaber: E.G.O. ELEKTRO-GERÄTEBAU GmbH, D-75038 Oberderdingen (DE)
(72) Erfinder: Kleinhans, Andreas, 75015 Bretten (DE)
(74) Vertreter: Patentanwälte Ruff, Wilhelm, Beier, Dauster & Partner

(56) Entgegenhaltungen:
- DE-A1- 19 706 168
- DE-A1- 19 746 323
- DE-U1- 29 603 484
- US-A- 4 482 845
- US-A1- 2003 048 632

## Beschreibung

Die Erfindung betrifft ein Bedienverfahren für ein Elektrogerät mittels eines Berührungsschalters oder Berührsensors an einer Bedienfläche und eine Bedieneinrichtung.

Es ist bekannt, beispielsweise aus der DE 197 06 168 A, an einem Glaskeramik-Kochfeld unter der Glaskeramik-Platte Berührungsschalter vorzusehen. Wird ein Finger auf einen solchen Berührungsschalter bzw. auf die Glaskeramik-Platte oberhalb des Berührungsschalters gelegt, so kann eine Funktion ausgelöst werden. Aufgrund der Natur der Berührungsschalter, für deren Bedienung unter Umständen kein mechanischer Bedienweg zurückgelegt werden muss, genügt ein relativ schwaches Darauftippen mit dem Finger bzw. Auflegen eines Fingers. Störungen oder Fehlbedienungen werden von einer solchen Steuerung dadurch ausgeschaltet bzw. unterdrückt, dass lediglich Betätigungen bzw. Sensorsignale in einem vorher festgelegten Bereich oder auf vorher festgelegte Art und Weise als bestimmungsgemäße und gewollte Betätigung definiert werden. So ist es beispielsweise möglich, eine zeitlich zu lange Betätigung des Berührungsschalters durch einen darüber befindlichen Gegenstand als Fehler bzw. nicht bestimmungsgemäße Betätigung einzustufen, beispielsweise wenn sie länger als 3 oder 10 Sekunden dauert. Dann kann davon ausgegangen werden, dass es sich hierbei nicht um eine gezielte Betätigung mit dem Finger durch eine Bedienperson handelt, sondern beispielsweise um einen versehentlich aufgelegten Gegenstand, der ebenfalls den Berührungsschalter auslöst. Nachteilig hierbei ist jedoch, dass zum Erkennen einer solchen nicht bestimmungsgemäßen Betätigung relativ viel Zeit benötigt wird. Dies birgt die Gefahr von Funktionsfehlern oder sogar Verletzungen oder Schäden durch ein ungewollt arbeitendes Elektrogerät.

Die US 4,482,845 beschreibt einen Berührungsschalter für eine Mehrfachbetätigung, wobei innerhalb einer sehr kurzen Zeitspanne eine zweimalige Betätigung notwendig ist zum Auslösen einer Funktion. Ein noch häufigeres Betätigen innerhalb kurzer Zeit ändert daran nichts. Möglichkeiten zur Nutzung einer noch häufigeren Betätigung sind darin jedoch nicht erläutert.

### Aufgabe und Lösung

Der Erfindung liegt die Aufgabe zugrunde, ein eingangs genanntes Bedienverfahren sowie eine Bedieneinrichtung zu schaffen, mit denen Probleme des Standes der Technik vermieden werden können und insbesondere auf neuartige und vorteilhafte Weise die Betätigung eines Elektrogeräts mit Berührungsschaltern sicherer gemacht wird.

Gelöst wird diese Aufgabe durch ein Bedienverfahren mit den Merkmalen des Anspruchs 1 sowie eine Einrichtung zur Durchführung des Bedienverfahrens mit den Merkmalen des Anspruchs 8. Vorteilhafte sowie bevorzugte Ausgestaltungen der Erfindung ergeben sich aus den weiteren Ansprüchen und werden im folgenden näher erläutert. Der Wortlaut der Ansprüche wird durch ausdrückliche Bezugnahme zum Inhalt der Beschreibung gemacht.

Erfindungsgemäß ist vorgesehen, dass durch ein zweimaliges oder mehrmaliges nachfolgendes Berühren der Bedienfläche an oder über dem Berührungsschalter, der im folgenden mit dem Berührsensor gleichgesetzt wird, innerhalb einer bestimmten Zeit oder mit einer bestimmten Frequenz eine dafür definierte Bedienfunktion ausgelöst wird. Dies bedeutet also, dass beispielsweise durch zweimaliges Antippen oder Berühren der Bedienfläche bzw. des Berührungsschalters genau dann eine entsprechende zugeordnete Funktion ausgelöst wird, wenn zwischen den beiden Betätigungen nicht mehr als eine bestimmte Zeit verstreicht. So kann vorgesehen sein, dass die maximal dazwischenliegende Zeit eine Sekunde ist. Ebenso kann beispielsweise vorgesehen sein, dass innerhalb von zwei Sekunden für eine weitere Bedienfunktion eine dreimalige Betätigung erfolgen muss bzw. der Berührungsschalter ein drittes Mal berührt werden muss.

Erfolgt die vorher definierte Anzahl der Berührungen nicht innerhalb einer bestimmten Zeit, so wird ein Fehlersignal ausgegeben und es erfolgt keine Bedienfunktion. Es ist vorgesehen, dass die mehrmalige Berührung bzw. Betätigung an derselben Stelle bzw. an dem gleichen Berührungsschalter stattzufinden hat. Zwar ist es grundsätzlich auch möglich, innerhalb der vorgeschriebenen Zeit zwei verschiedene Berührungsschalter nacheinander zu betätigen. Das macht eine Bedienung für eine Bedienperson jedoch aufwändiger, da ein Wechsel des Betätigungsortes innerhalb kurzer Zeit aufwändig ist bzw. Bedienfehler hervorrufen kann.

Vorteilhaft ist die bestimmungsgemäße Bedienung bzw. Auslösung so festgelegt, dass sie leicht und eben mit der notwendigen Wiederholung bzw. Schnelligkeit durchgeführt werden kann. Dafür eignet sich ein leichtes Antippen, das man unter Umständen auch als solches hören kann.

Als zeitlicher Abstand, in dem die Bedienung bzw. der Bedienvorgang zu erfolgen hat, sind Zeitabschnitte im Bereich weniger Sekunden von Vorteil. So kann es beispielsweise vorgesehen sein, zwischen zwei nachfolgenden Betätigungen nicht mehr als zwei Sekunden vergehen zu lassen, vorteilhaft etwa eine Sekunde oder sogar noch weniger.

An einem solchen Berührungsschalter bzw. bei dieser Art von Bedienfunktion ist es erfindungsgemäß vorgesehen, dass bei lediglich einmal erfolgter Bedienung bzw. Berühren keine Bedienfunktion ausgelöst wird. Erst nach der vorgeschriebenen mehrmaligen Betätigung innerhalb einer bestimmten Zeit erfolgt die Auslösung einer zugeordneten Bedienfunktion. Wie bereits zuvor ausgeführt worden ist, wird diese nicht bestimmungsgemäße Bedienung bzw. der Bedienversuch einer Bedienperson als solches angezeigt.

Es ist auch möglich, einen Berührungsschalter so auszulegen, dass er zu einem bestimmten Zeitpunkt, beispielsweise bei ausgeschaltetem Elektrogerät, nach zweimaligem Berühren innerhalb kurzer Zeit das Elektrogerät einschaltet. Danach kann er seine Funktion wechseln und als Berührungsschalter arbeiten, der bereits nach einmaliger Berührung eine Bedienfunktion auslöst. Somit könnte durch das erfindungsgemäße Bedienverfahren eine Art Sicherheitsfunktion sowie eine Mehrfachbelegung eines Berührungsschalters erfolgen.

Der Berührungsschalter ist erfindungsgemäß dafür ausgelegt, bei zweimaliger Betätigung innerhalb kurzer Zeit eine erste bestimmte Funktion auszuüben und bei dreimaliger Betätigung eine andere zweite Funktion. So ist eine weitere Mehrfachbelegung von Berührungsschaltern möglich und deren Anzahl kann reduziert werden. Dies ermöglicht den Bau günstigerer und vor allem auch kleinerer Bedieneinheiten.

Es kann vorgesehen sein, dass beispielsweise in einer Steuerung des Elektrogerätes von einer Bedienperson individuell eingestellt werden kann, wie lange die Zeitintervalle sind, innerhalb derer die mehrfache Betätigung zu erfolgen hat. So ist eine individuelle Anpassung möglich, mit der jede Bedienperson die für sie am besten zusagende und im praktischen Gebrauch bewährte Einstellung finden kann.

Des weiteren kann vorgesehen sein, jede einzelne Berührung eines Berührungsschalters optisch oder akustisch zu quittieren, beispielsweise mit einem kurzen Signalton. Nach bestimmungsgemäßer erfolgter Auslösung der Bedienfunktion wird auch dies vorteilhaft angezeigt.

Grundsätzlich ist es möglich, einem mehrfachen Bedienen eines Berührungsschalters innerhalb einer kurzen vorgegebenen Zeit eine Bedienfunktion zuzuordnen. Dabei kann vorgesehen sein, ein einmaliges Bedienen, dem in einer vorgegebenen Zeit kein zweites Bedienen folgt, bereits als Bedienung anzusehen und eine Bedienfunktion zuzuordnen bzw. auszulösen. Es kann auch vorgesehen sein, ein darüber hinausgehendes drei- oder mehrfaches Bedienen, beispielsweise als dreifaches Antippen eines Berührungsschalters, mit einer ganz speziellen zugeordneten Bedienfunktion zu versehen.

Alternativ kann vorgesehen sein, dass an einem Berührungsschalter allgemein oder an bestimmten Punkten innerhalb eines Bedienmenüs ausschließlich ein doppeltes Bedienen oder Antippen eine Bedienfunktion auslöst. Somit kann je nach Bedarf der Schwerpunkt entweder darauf gelegt werden, eine erhöhte Bediensicherheit zu erreichen, oder aber mit einer geringen Anzahl von Berührungsschaltern möglichst viele Bedienfunktionen durch eine Art Mehrfach-Funktionalität zu realisieren.

Ein Elektrogerät, in dem das erfindungsgemäße Verfahren durch die erfindungsgemäße Bedieneinrichtung realisiert ist, kann vorteilhaft ein elektrisches Haushaltsgerät sein, insbesondere mit einer größeren Anzahl von Funktionen wie beispielsweise ein Kochfeld oder ein Backofen. Die Berührungsschalter oder Berührungssensoren sind an einer vorgenannten Berührfläche angeordnet. Eine solche Berührfläche kann zwar mehrere, unter Umständen aber auch nur einen Berührungsschalter oder Berührungssensor aufweisen. Beispielsweise kann es bei einem Kochfeld ein Teil der als Kochfeldplatte dienenden Glaskeramik-Platte sein, insbesondere in einem vorderen Bereich. Ebenso könnten die Berührungsschalter auch unter einem die Kochfeldplatte umgebenden Rahmen angeordnet sein.

Zu den Berührungsschaltern ist noch zu bemerken, dass sie vorteilhaft so ausgewählt werden, dass für ihre Bedienung oder Auslösung gar kein oder nur ein relativ geringer Auslöseweg sowie eine relativ geringe Betätigungs- oder Auslösekraft benötigt wird. Besonders geeignet sind Berührungsschalter ohne jeglichen Auslöseweg bzw. ohne mechanische Funktion, insbesondere kapazitive oder optische Berührungsschalter.

Diese und weitere Merkmale gehen außer aus den Ansprüchen auch aus der Beschreibung und den Zeichnungen.

### Kurzbeschreibung der Zeichnung

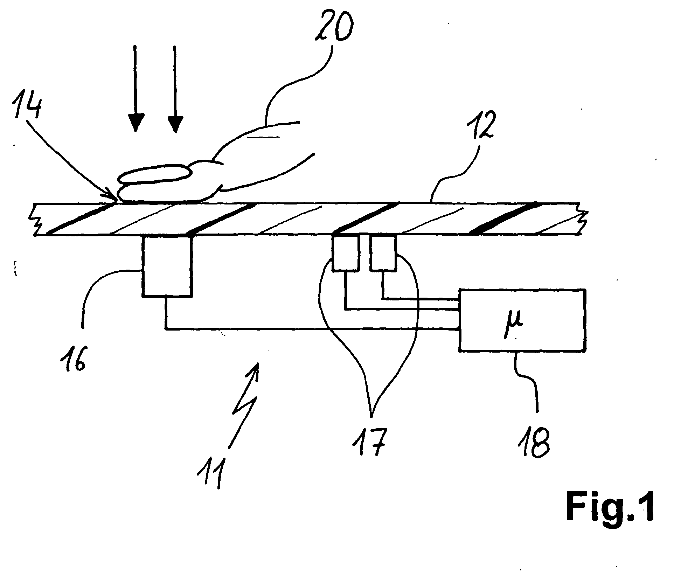

Die einzige Zeichnungsfigur Fig. 1 zeigt schematisch im Schnitt durch eine erfindungsgemäße Bedieneinrichtung zur Durchführung des vorbeschriebenen Bedienverfahrens.

### Detaillierte Beschreibung des Ausführungsbeispiels

In Fig. 1 ist eine Bedieneinrichtung 11 dargestellt, welche an einer Glaskeramik-Platte 12 angeordnet ist bzw. eine solche aufweist. Die Glaskeramik-Platte 12 kann beispielsweise die Kochfeld-Platte eines Kochfeldes sein. Alternativ kann sie aus einem anderen Material bestehen und eine oder mehrere Bedienflächen 14 aufweisen. Die Bedienfläche 14 entspricht der ansonsten bei der Verwendung von Berührungsschaltern üblichen Bedienfläche, welche insbesondere bei Kochfeld-Platten aus Glaskeramik durch entsprechende Markierungen oder Farbaufdrucke an der Oberseite kenntlich gemacht sind.

Unter der Glaskeramik 12 bzw. genau unter der Bedienfläche 14 ist ein kapazitiver Berührungsschalter 16 ausgebildet, insbesondere als kapazitives Sensorelement, wie es beispielsweise aus der DE 197 06 168 A bekannt ist, auf welche diesbezüglich ausdrücklich Bezug genommen wird. Alternativ sind neben dem kapazitiven Berührungsschalter 16 noch optische Berührungsschalter 17 angeordnet, welche beispielsweise als Reflex-Lichtschranken arbeiten. Die Berührungsschalter 16 und 17 sind an eine Steuerung 18 angeschlossen, durch welche sie angesteuert werden und mit der ihre Ausgangssignale ausgewertet werden, insbesondere hinsichtlich des Vorliegens einer Bedienung.

Wie dargestellt ist, ist ein Finger 20 auf die Bedienfläche 14 aufgelegt. Durch die beiden Pfeile wird veranschaulicht, dass er zweimal aufgelegt bzw. aufgetippt wurde. Erfolgt dieses zweimalige Auflegen oder Auftippen innerhalb einer bestimmten vorgegebenen Zeit, beispielsweise innerhalb von einer Sekunde, so wird dies zum einen durch die Steuerung 18 erkannt. Die Steuerung 18 löst dann die diesem zweimaligen Auftippen entsprechende Bedienfunktion aus, beispielsweise ein Ein- oder Ausschalten eines zu der Bedieneinrichtung 11 gehörenden Elektrogerätes.

Anstelle eines zweimaligen Antippens, wie in Fig. 1 dargestellt, kann auch ein noch häufigeres Antippen für die Auslösung einer Bedienfunktion erforderlich sein. Alternativ ist es möglich, unterschiedlich häufigem Antippen jeweils unterschiedliche Bedienfunktionen zuzuordnen. Darüber hinaus ist es möglich, die Zeitspanne, innerhalb welcher das zweimalige oder mehrmalige Antippen erfolgen muß, variabel zu machen, insbesondere auch in Abhängigkeit von der Häufigkeit des Antippens zum Auslösen der Bedienfunktion.

Um eine Anpassung an das Bedienverhalten einer Bedienperson zu erreichen, kann vorgesehen sein, dass die Zeit, innerhalb welcher das mehrmalige Antippen bis zum Auslösen einer Bedienfunktion erfolgen muß, eingestellt werden kann, insbesondere auch in einem Einstell-Modus von der Bedienperson selber. Somit kann eine Art Benutzeranpassung erfolgen.

## Patentansprüche

1. Bedienverfahren für ein Elektrogerät mit einer Bedienfläche und mit einem Berührungsschalter (16, 17) oder Berührsensor, wobei der Berührungsschalter oder Berührsensor an oder unter der Bedienfläche (14) angeordnet ist und auf der Bedienfläche die Berührung zur Bedienung stattfindet, wobei ein zweimaliges oder mehrmaliges aufeinander folgendes Berühren der Bedienfläche (14) an oder über dem Berührungsschalter (16, 17) oder Berührsensor innerhalb einer bestimmten Zeit oder mit einer bestimmten Frequenz erkannt wird und dadurch eine dafür definierte Bedienfunktion ausgelöst wird, **dadurch gekennzeichnet, dass** nach lediglich einmalig erfolgter Berührung keine Bedienfunktion ausgelöst wird und dieser nicht bestimmungsgemäße Bedienversuch als solches einer Bedienperson angezeigt wird, wobei zwischen einem zweimaligen und einem darüber hinausgehenden dreimaligen oder mehrmaligen Berühren ein Unterschied gemacht wird und jeweils unterschiedliche Bedienfunktionen ausgelöst werden.

2. Bedienverfahren nach Anspruch 1, **dadurch gekennzeichnet, dass** nur eine mehrmalige Berührung an derselben Stelle bzw. an einem einzigen Berührungsschalter (16, 17) oder Berührsensor als zusammengehörend gewertet wird.

3. Bedienverfahren nach Anspruch 1 oder 2, **dadurch gekennzeichnet, dass** die Berührung mit einer Kraft stattfindet, die einem leichten und hörbaren Antippen mit einem Finger (20) entspricht.

4. Bedienverfahren nach einem der vorhergehenden Ansprüche, **dadurch gekennzeichnet, dass** der zeitliche Abstand zwischen zwei nachfolgenden Berührungen unter zwei Sekunden liegt, vorzugsweise unter einer Sekunde.

5. Bedienverfahren nach einem der vorhergehenden Ansprüche, **dadurch gekennzeichnet, dass** nach lediglich einmalig erfolgter Berührung keine Bedienfunktion ausgelöst wird bzw. keine Bedienung erkannt wird.

6. Bedienverfahren nach einem der vorhergehenden Ansprüche, **dadurch gekennzeichnet, dass** durch optische oder akustische Anzeige jede einzelne Berührung zumindest kurzzeitig angezeigt wird.

7. Bedienverfahren nach einem der vorhergehenden Ansprüche, **dadurch gekennzeichnet, dass** das Auslösen einer vorgesehenen Bedienfunktion durch optische oder akustische Anzeige angezeigt wird.

8. Bedieneinrichtung (11) angepasst zur Durchführung des Bedienverfahrens nach einem der vorhergehenden Ansprüche, wobei sie mindestens einen Berührungsschalter (16, 17) oder Berührsensor an oder unter einer Bedienfläche (14) aufweist, auf welcher die Berührung zur Bedienung stattfindet.

## Claims

1. Operating method for an electrical appliance having an operating surface and a touch switch (16, 17) or touch sensor, where the touch switch or touch sensor is arranged on or underneath the operating surface (14) and the touch for operation takes place on the operating surface, where touching the operating surface on or above the touch switch (16, 17) or touch sensor twice or several times in succession within a certain time or with a certain frequency is detected and an operating function defined for this is actuated, **characterized in that** after touching only once an operating function is not actuated and this non-regulation attempt at operation is indicated as such to an operator, where a distinction is made between touching twice and touching three or more times in addition and in each case different operating functions are actuated.

2. Operating method according to Claim 1, **characterized in that** only a touch of the same place or of a single touch switch (16, 17) or of a touch sensor several times is classed as a single action.

3. Operating method according to Claim 1 or 2, **characterized in that** touching is done with a force corresponding to a light and audible tap with a finger (20).

4. Operating device according to one of the preceding claims, **characterized in that** the time interval between two consecutive touches is less than two seconds, preferably less than one second.

5. Operating method according to one of the preceding claims, **characterized in that** after only one touch an operating function is not actuated and an operation is not detected.

6. Operating method according to one of the preceding claims, **characterized in that** every single touch is at least briefly indicated by an optical or acoustic indicator.

7. Operating method according to one of the preceding claims, **characterized in that** the actuation of an intended operating function is indicated by an optical or acoustic indicator.

8. Operating device (11) adapted for performance of the operating method according to one of the preceding claims, having at least one touch switch (16, 17) or touch sensor on or underneath an operating surface (14) on which the touch for operation is made.

## Revendications

1. Méthode de commande pour un appareil électrique avec une surface de commande et un commutateur tactile (16, 17) ou un capteur tactile, selon laquelle le commutateur tactile ou le capteur tactile est disposé sur ou sous la surface de commande (14) et le contact pour la commande a lieu sur la surface de commande, sachant qu'un contact effectué deux fois ou plusieurs fois consécutives sur la surface de commande (14) est détecté sur ou via le commutateur tactile (16, 17) ou le capteur tactile à l'intérieur d'un certain intervalle de temps ou avec une certaine fréquence et que de ce fait est déclenchée une fonction de commande définie à cet effet, **caractérisée en ce qu'**après un contact effectué seulement une fois, aucune fonction de commande n'est déclenchée et que cette tentative de commande non conforme est signalé en tant que telle à une personne chargée de la commande, sachant qu'il est fait une distinction entre un contact effectué deux fois et un contact allant au-delà effectué trois fois ou davantage, et que dans chaque cas, des fonctions de commande différentes sont déclenchées.

2. Méthode de commande selon la revendication 1, **caractérisée en ce que** seuls des contacts répétés effectués au même endroit ou sur un unique commutateur tactile (16, 17) ou capteur tactile sont considérés comme connexes.

3. Méthode de commande selon la revendication 1 ou 2, **caractérisée en ce que** le contact a lieu avec une force qui correspond à un tapement léger et audible avec un doigt (20).

4. Méthode de commande selon l'une des revendications précédentes, **caractérisée en ce que** l'intervalle de temps entre deux contacts successifs est inférieur à deux secondes, de préférence inférieur à une seconde.

5. Méthode de commande selon l'une des revendications précédentes, **caractérisée en ce qu'**après un contact effectué seulement une fois, aucune fonction de commande n'est déclenchée ou aucune commande n'est détectée.

6. Méthode de commande selon l'une des revendications précédentes, **caractérisée en ce que** chaque contact individuel est signalé au moins un court instant par un signal optique ou acoustique.

7. Méthode de commande selon l'une des revendications précédentes, **caractérisée en ce que** le déclenchement d'une fonction de commande prévue est signalé par un signal optique ou acoustique.

8. Dispositif de commande (11) adapté pour réaliser la méthode de commande selon l'une des revendications précédentes, et qui présente au moins un commutateur tactile (16, 17) ou un capteur tactile sur ou sous un surface de commande (14) sur laquelle a lieu le contact pour la commande.
